# EUROPÄISCHE PATENTSCHRIFT

(11) **EP 1 218 566 B1**
(45) Veröffentlichungstag und Bekanntmachung des Hinweises auf die Patenterteilung: **05.03.2003**
(21) Anmeldenummer: 00960317.6
(22) Anmeldetag: 18.07.2000
(51) Int. Cl.: C23F 1/02

(54) **VERFAHREN ZUM BILDEN EINES LEITERMUSTERS AUF DIELEKTRISCHEN SUBSTRATEN**
METHOD FOR PRODUCING A CONDUCTOR PATTERN ON A DIELECTRIC SUBSTRATE
PROCEDE POUR FORMER UN MOTIF CONDUCTEUR SUR UN SUBSTRAT DIELECTRIQUE

(30) Priorität: 10.09.1999 DE 19944908
(43) Veröffentlichungstag der Anmeldung: 03.07.2002
(73) Patentinhaber: ATOTECH Deutschland GmbH, 10553 Berlin (DE)
(72) Erfinder: GUGGEMOS, Michael, D-14523 Stahnsdorf (DE); KOHNLE, Franz, D-12357 Berlin (DE)
(74) Vertreter: Effert, Bressel und Kollegen
(86) Internationale Anmeldenummer: DE0002423
(87) Internationale Veröffentlichungsnummer: WO01020059

(56) Entgegenhaltungen:
- EP-A- 0 619 333
- WO-A-97/15173
- WO-A-98/33951
- DE-A- 2 061 580
- DE-A- 4 222 968
- DE-A- 4 339 019
- US-A- 3 547 629
- US-A- 5 114 831
- US-A- 5 294 519

## Beschreibung

Die Erfindung betrifft ein Verfahren zum Bilden eines Leitermusters auf mit einer Metallschicht, vorzugsweise Kupferschicht, überzogenen dielektrischen Substraten.

Zur Herstellung von Leitermustern auf elektrischen Schaltungsträgern sind in der Vergangenheit sehr viele unterschiedliche Verfahren vorgeschlagen worden. Beim Panel-Plating-Verfahren wird zunächst eine das gebohrte Leiterplattenmaterial allseitig umschließende Kupferschicht in der für die Leiterstrukturen erforderlichen Dicke erzeugt. Anschließend werden die Bereiche der Leiterplatten-Außenseiten durch eine Resistschicht abgedeckt, die den zu bildenden Leiterstrukturen entsprechen, so daß diese Bereiche beim anschließenden Ätzverfahren erhalten bleiben. Beim Pattern-Plating-Verfahren wird zunächst nur eine dünne Kupferschicht auf dem Leiterplattenmaterial gebildet. Darauf wird beispielsweise eine Photoresistschicht aufgetragen und die Kupferschicht an den Stellen durch Photostrukturierung wieder freigelegt, die den zu bildenden Leiterstrukturen entsprechen. Auf die freigelegten Kupferbereiche wird eine Metallschicht aufgebracht. Anschließend wird die Photoresistschicht entfernt und die freigelegte Kupferschicht weggeätzt. Beim Unterfall des Metallresistverfahrens wird als Galvanoresist eine Metallresistschicht aufgebracht, beispielsweise eine Zinn/Blei-Schicht.

Diese Verfahren weisen erhebliche Nachteile auf. Insbesondere ist es nicht möglich, unter Produktionsbedingungen Leiterstrukturen mit Strukturbreiten von weniger als 100 µm reproduzierbar herzustellen. Zwar hat es nicht an Versuchen gefehlt, dieses Ziel zu erreichen. Mit einigen aufwendigen Verfahren und Ausgangsmaterialien ist es auch gelungen, derartige Schaltungen herzustellen. Für die Massenfertigung kommen derartige Verfahren jedoch nicht in Betracht, da sie zu teuer und aufwendig sind und/oder sehr teure Ausgangsprodukte erfordern. Zur Herstellung von Schaltungen mit Strukturbreiten der Leiterzüge von weniger als 50 µm sind diese Verfahren aber nicht geeignet.

Als alternative Ätzresistschicht wurde auch eine aus Imidazol- oder Benzimidazolderivaten gebildete Schicht vorgeschlagen. Beispielsweise ist in EP 0 178 864 A2 ein Verfahren zur Herstellung einer mit Kupfer durchkontaktierten Leiterplatte beschrieben, das darin besteht, daß zuerst das gewünschte Schaltungsmuster auf der Kupferkaschierung mit einem alkalilöslichen Resist gebildet wird, anschließend eine Ätzresistschicht durch in-Kontakt-Bringen der Platte mit einer wäßrigen Lösung eines Alkylimidazois an den freiliegenden Stellen gebildet wird, die Platte anschließend getrocknet und das freiliegende Kupfer nachfolgend mit einer alkalischen Ätzlösung durch Ätzen entfernt wird.

In EP 0 364 132 A1 ist erwähnt, daß Lösungen, die zum Bilden einer Schutzschicht gegen das Anlaufen geeignet sind, auch als Ätzresiste verwendet werden können. Derartige Lösungen enthalten Imidazolverbindungen mit einer C₅₋₂₁-Alkylkette und zusätzlich Kupfer- oder Zinkionen.

In EP 0 619 333 A2 sind Verfahren zur Herstellung von Leiterstrukturen beschrieben, bei denen Stickstoff enthaltende Verbindungen verwendet werden, um eine Ätzresistschicht zu bilden. Als Stickstoff enthaltende Verbindungen werden unter anderem mit einer Alkylkette mit mindestens drei Kohlenstoffatomen substituierte Verbindungen aus der Gruppe Imidazole, Benzimidazole, Triazole, Benzotriazole, Pyrrole, Pyrazole, Oxazole, Isoxazole, Thiazole, Benzothiazole, Indole, Adenin, Purin, Chinoline, Pyrazine. Chinazoline, Guanin, Xanthin, Hypoxanthin, Indazole, Kreatinin, Phenazine und Kupferron eingesetzt. Zur Herstellung der Leiterstrukturen wird zuerst ein Negativbild mit einem üblichen alkalisch entfernbaren Resist gebildet, dann die Platte an den freiliegenden Bereichen mit der die Stickstoffverbindungen enthaltenden Ätzresistschicht überzogen und danach der Negativresist wieder entfernt. Anschließend kann die Leiterstruktur durch Ätzen gebildet werden.

In DE 43 39 019 A1 ist ein weiteres Verfahren unter Verwendung einer aus Imidazol- und/oder Benzimidazol entstehenden Schutzschicht beschrieben. In diesem Falle wird die Schutzschicht ausschließlich auf den Lochwänden gebildet, nachdem auf den Leiterplatten-Außenseiten bis an die Lochränder heran eine andere Schicht gebildet worden ist, die die Bildung der Schutzschicht dort verhindert. Wird für diese andere Schicht ein photosensitiver Lack verwendet, so können die Leiterstrukturen durch Photostrukturierung erzeugt werden.

In DE 37 32 249 A1 ist ein Verfahren zur Herstellung von dreidimensionalen Leiterplatten in Subtraktiv/Semiadditiv-Technik mit Bildübertragung auf einem isolierenden Substrat angegeben, bei dem das mit einer Kupferschicht überzogene Substrat zunächst mit einem stromlos und/oder galvanisch abscheidbaren Zinn-Metallresist allseitig beschichtet und der Metallresist anschließend mit Laserstrahlung maskenlos selektiv bestrahlt wird, so daß das Leitermuster als Negativ entsteht. Die freigelegten Kupferbereiche können anschließend durch Ätzen entfernt werden.

In DE 41 31 065 A1 ist ein Verfahren zur Herstellung von Leiterplatten angegeben, bei dem auf ein elektrisch isolierendes Substrat nacheinander eine Metallschicht und eine Ätzresistschicht aufgebracht werden, die Ätzresistschicht in den unmittelbar an das spätere Leiterbahnmuster angrenzenden Bereichen durch elektromagnetische Strahlung wieder entfernt wird und die freigelegten Bereiche der Metallschicht bis zur Oberfläche des Substrats derart weggeätzt werden, daß das Leiterbahnmuster und durch Ätzgräben elektrisch davon isolierte Inselbereiche der Metallschicht auf dem Substrat verbleiben. Vorzugsweise wird die Ätzresistschicht durch stromlose Metallabscheidung gebildet. Alternativ dazu kann auch ein organisches Material, beispielsweise ein Elektrotauchlack, verwendet werden. Zur Erzeugung der elektromagnetischen Strahlung wird vorzugsweise ein Laser, insbesondere ein Nd-YAG-Laser eingesetzt. Die Ätzgräben sind 150 µm breit. Beim Ätzen der Metallschicht, vorzugsweise einer Kupferschicht, wird an den Flanken der Ätzgräben eine Unterätzung von jeweils 35 µm festgestellt.

In EP 0 757 885 B1 ist ein Verfahren zur Bildung metallischer Leitermuster mit löt und/oder bondbaren Anschlußbereichen auf elektrisch isolierenden Unterlagen offenbart, bei dem zunächst eine Metallisierung auf die Unterlage und dann eine organische, galvano- und ätzresistente Schutzschicht In einem Elektrotauchbad auf die Metallisierung aufgebracht wird, danach die Schutzschicht in den späteren Anschlußbereichen mittels Laserstrahlung wieder entfernt wird, dann eine ätzresistente, löt- und/oder bondbare Endoberfläche auf die freigelegten Bereiche der Metallisierung galvanisch abgeschieden wird, die Schutzschicht zumindest in den unmittelbar an das spätere Leitermuster angrenzenden Bereichen mittels Laserstrahlung entfernt wird und schließlich die freigelegten Bereiche der Metallisierung bis zur Oberfläche der Unterlage abgeätzt werden. Auch in diesem Falle wird beispielhaft ein Nd-YAG-Laser als Strahlungsquelle genannt. Die gebildeten Ätzgräben weisen eine Breite von 150 µm auf.

In DE-OS 2 061 580 ist ein Verfahren zur Herstellung von gedruckten Schaltungen beschrieben, bei dem auf einen Schichtkörper, der eine elektrisch isolierende Trägerschicht und eine Metallschicht aufweist, eine Schicht eines gegen ein Ätzmittel beständigen, Licht absorbierenden, insbesondere Ruß enthaltenden und pyrolysierbaren Stoffes aufgebracht wird, daß ferner zwischen der pyrolysierbaren Schicht und einer Xenon-Blitzlichtröhre eine lichtundurchlässige Maskierung angeordnet wird und daß weiterhin durch Bestrahlung mit dem Blitzlicht die pyrolysierbare Schicht dort weggebrannt wird, wo sie nicht durch die Maskierung geschützt ist. Anschließend werden entfernt: die Maskierung, danach aus der Metallschicht diejenigen Stellen, die nicht von den verbliebenen Teilen der pyrolysierbaren Schicht bedeckt sind, und schließlich die verbliebenen Teile der pyrolysierbaren Schicht.

Die bekannten Verfahren sind entweder äußerst aufwendig und damit teuer, oder es gelingt nicht, sehr feine Strukturen mit einer Strukturbreite von 50 µm und weniger, insbesondere von höchstens 20 µm, reproduzierbar herzustellen. Die einzige bekannte Möglichkeit besteht darin, von einem Material auszugehen, das eine höchstens 5 µm dicke Kupferschicht aufweist. Jedoch ist es verfahrenstechnisch außerordentlich aufwendig und damit teuer, derartige Materialien herzustellen. Bei Verwendung der üblichen Materialien mit einer dicken Kupferschicht zeigt sich, daß die Leiterstrukturen wegen einer nicht unbeträchtlichen Unterätzung meist keinen rechteckigen Querschnitt aufweisen, so daß deren Auflagefläche auf dem Substrat sehr klein ist und damit die gewünschte Haftfestigkeit der Leiterzüge nicht erreicht wird.

Der vorliegenden Erfindung liegt von daher das Problem zugrunde, die Nachteile der bekannten Verfahren zu vermeiden und insbesondere ein Verfahren zu finden, mit dem eine leichte, auch in der Massenfertigung durchführbare Strukturierung möglich ist, die es erlaubt, feinste Strukturen mit Strukturbreiten von 50 µm und weniger, insbesondere von 20 µm und weniger, reproduzierbar herzustellen. Außerdem sollen die mit den bekannten Verfahren bestehenden Probleme hinsichtlich der weiteren Prozessierbarkeit der fertiggestellten Leitermuster nicht auftreten. Auch die Form der Leiterzüge soll reproduzierbar sein und der Querschnitt einer Rechteckform möglichst nahekommen. Damit soll auch gewährleistet sein, daß die Lelterzüge zur Herstellung hochintegrierter Schaltungen im sogenannten "landless design" an die Metallschicht in den Ausnehmungen sicher ankontaktiert werden. Beim "landless design" werden keine Kupferringe um vorhandene zur elektrischen Verbindung mehrerer Leiterzugebenen dienende Ausnehmungen gebildet. Vielmehr gehen die Leiterzüge ohne Verbreiterung in die Metallisierung der Wände der Ausnehmungen über.

Gelöst wird dieses Problem durch das Verfahren nach Anspruch 1. Bevorzugte Ausführungsformen der Erfindung sind in den Unteransprüchen angegeben.

Das erfindungsgemäße Verfahren dient zum Bilden eines Leitermusters auf dielektrischen Substraten.

Insbesondere wird das Verfahren eingesetzt, um hochintegrierte Schaltungsträger für die Mikroelektronik zu erzeugen. Das Verfahren kann natürlich auch zur Herstellung anderer Produkte angewendet werden, beispielsweise zur Herstellung von Mikroreaktoren, Speichermedien, Solarkollektoren und Metallmustern auf Kunststoffen zur Erzeugung dekorativer Effekte.

Zur Durchführung des erfindungsgemäßen Verfahrens wird ein mit einer Metall-schicht, vorzugsweise Kupferschicht, überzogenes Substrat verwendet und die Metallschicht nach der erfindungsgemäßen Strukturierung durch Ätzen entfernt, so daß das gewünschte Leitermuster entsteht. Zur Strukturierung der Metallschicht wird
a) das Substrat mit einer Schutzschicht beschichtet, die durch Behandeln der Metallschicht mit einer mindestens eine Stickstoff enthaltende Verbindung enthaltenden Lösung gebildet wird, und
b) die Schutzschicht anschließend in den dem zu bildenden Leitermuster nicht entsprechenden Bereichen durch UV-Strahlung derart abgetragen, daß die Metallschicht freigelegt wird, wobei als Stickstoff enthaltende Verbindungen
   i. mit Alkyl-, Aryl- undloder Aralkylgruppen substituierte cyclische Verbindungen eingesetzt werden, nämlich Verbindungen aus den Substanzklassen: Imidazole, Benzimidazole, Triazole, Benzotriazole, Pyrrole, Pyrazole, Oxazole, Isoxazole, Thiazole, Benzothiazole, Indole, Adenin, Purine, Chinoline, Pyrazine, Chinazoline, Guanin, Xanthin, Hypoxanthin, indazole, Kreatinin, Phenazine, Kupferron, Tetrazole, Thiadiazote, Thiatriazole, Isothiazole sowie deren Derivate, wobei die Alkylgruppen mindestens drei Kohlenstoffatome aufweisen, oder
   ii. Oligomer- oder Polymerketten enthaltende Verbindungen, an die die vorstehend genannten Verbindungen gebunden sind; beisplelsweise bildet Polyvinylimidazol eine äußerst ätzresistente Ätzschicht.
   Danach kann
c) die freigelegte Metallschicht durch Ätzen entfernt werden.

Als Energiestrahlung wird vorzugsweise Laserstrahlung eingesetzt, da diese Strahlung die geforderten Eigenschaften aufweist, um die äußerst feinen Strukturen herstellen zu können, und da in der Laserstrahlung auch eine genügend hohe Energiedichte erreicht wird, um die Schutzschicht abzutragen.

Zur selektiven Entfernung der Schutzschicht in den freizulegenden Metallschichtbereichen wird vorzugsweise ein Excimer-Laser eingesetzt, der insbesondere gepulst sein kann. Diese Strahlungsquelle ist besonders gut geeignet, um die aus organischem Material bestehenden dünnen Schutzschichten rückstandsfrei abzutragen. Grundsätzlich können auch andere Lasertypen eingesetzt werden. Bei Verwendung dieser Lasertypen kann jedoch nicht gewährleistet werden, daß die Schutzschichten rückstandsfrei entfernt werden.

Mit dem erfindungsgemäßen Verfahren können Leitermuster gebildet werden, die Strukturbreiten der Leiterzüge von 50 µm und weniger und insbesondere von 20 µm und weniger aufweisen. Beispielsweise können Leiterzüge mit einem nahezu rechteckigen Querschnitt mit einer Basisbreite von 15 µm gebildet werden. Die Form des Leiterzug-Querschnitts entspricht im wesentlichen einem Trapez, wobei festgestellt wurde, daß die am Dielektrikum anliegende Basisfläche der Leiterzüge breiter ist als die Oberfläche. Dadurch wird eine große Kontaktfläche der Leiterzüge zum Dielektrikum und damit eine optimale Haftfestigkeit auf dem Substrat erreicht. Die als Unterätzung bezeichnete Steilheit der Leiterzugflanken liegt bei etwa 20 µm breiten und etwa 20 µm hohen Leiterzügen im Bereich von 2,5 µm. Das bedeutet, daß die Basisfläche an jeder Flanke der Leiterzüge um die angegebene Strecke unter der Oberfläche der Leiterzüge hervorragt. Werden beispielsweise Leiterzüge mit einer Basisflächenbreite von 15 µm hergestellt, so ergibt sich ein Breite der Leiterzugoberfläche von etwa 11 µm.

Die Leiterzugbreite kann auch reproduzierbar eingestellt werden. Beispielsweise können Leiterzüge mit einer im wesentlichen konstanten Strukturbreite von etwa 20 µm oder auch weniger (beispielsweise 10 µm) erhalten werden. Die Schwankung der Breite liegt jedenfalls innerhalb von etwa ± 1 µm. Dadurch wird die elektrische Integrität der gesamten elektrischen Schaltung gesichert, d.h. beispielsweise, daß eine reproduzierbare Impedanz der Schaltung gewährleistet ist.

Insbesondere treten bei Anwendung des erfindungsgemäßen Verfahrens nicht die Probleme auf, die mit dem in DE 37 32 249 A1 beschriebenen Verfahren beobachtet werden. Ausfälle beim nachfolgenden Ätzen der freigelegten Kupferschicht werden nicht beobachtet. Alle Oberflächenbereiche der zu bearbeitenden Schaltung, in denen die Schutzschicht durch die Laserbehandlung entfernt wird, können problemlos geätzt werden, ohne daß Reste zurückbleiben. Bei Anwendung des in DE 37 32 249 A1 beschriebenen Verfahrens wird dagegen festgestellt, daß auch nach dem Laserabtrag noch erhebliche Mengen von Zinn in den an sich zuvor von Zinn befreiten Kupferoberflächenbereichen zu finden sind, so daß das Ätzresultat nicht befriedigend ist. Grundsätzlich ist dieses Verfahren nur zur Herstellung von Leiterzügen mit einer minimalen Breite von etwa 120 um geeignet. Wird versucht, mit diesem Verfahren Schaltungsträger mit Strukturbreiten der Leiterzüge von weniger als 50 µm herzustellen, so werden keine reproduzierbaren Ergebnisse mehr erhalten. Die Form und Breite der Leiterzüge schwankt in sehr weiten Grenzen. Teilweise sind die Zwischenräume zwischen den Leiterzügen sogar entweder miteinander verbunden, oder es werden Unterbrechungen der Leiterzüge beobachtet. Teilweise wurden auch lochfraß-ähnliche Ausätzungen des Leitermusters nach dem Entfernen der Kupferschicht durch Ätzen beobachtet.

Außerdem bereiten die mit diesem Verfahren hergestellten Leitermuster häufig Probleme bei nachfolgenden Verfahren, beispielsweise beim Aufbringen einer Lötstopmaske und bei Verfahren, bei denen als Endschichten Nickel/Gold-Schichtkombinationen abgeschieden werden. Im ersteren Falle haftet die Maske nicht ausreichend auf den Leiterstrukturen, und im zweiten Falle können die von der Zinnschicht wieder befreiten Kupferstrukturen nicht einwandfrei angeätzt werden, um die Nickel/Gold-Schicht zu bilden. Ferner ist es nicht ohne weiteres möglich, die Zinnschicht nach dem Ätzen aus feinen Bohrungen wieder zu entfernen. Insbesondere bei der Bearbeitung von Substraten mit Sacklöchern stellen sich erhebliche Probleme bei der Entfernung der Zinnschicht aus den Löchern ein. Außerdem müssen sehr teure und abwassertechnisch bedenkliche Ätzlösungen zur Entfernung der Zinnschicht eingesetzt werden.

Beim Einsatz der in DE 41 31 065 A1 und EP 0 757 885 B1 beschriebenen Verfahren werden keine befriedigenden Ergebnisse bei der Herstellung von Schaltungsträgern mit Leiterzugbreiten von weniger als etwa 75 µm erhalten. In diesem Falle sind die Leiterzugflanken ebenfalls nicht exakt definiert, so daß der weiterführende Versuch, Leiterzüge mit einer Breite von 50 µm und weniger zu erzeugen, völlig fehlschlägt. Außerdem wird auch in diesem Falle beobachtet, daß beim Abtragen der organischen Schutzschichten mit der Laserstrahlung Rückstände auf den Metalloberflächen verbleiben, so daß sich Probleme beim nachfolgenden Ätzen ergeben.

Mit dem erfindungsgemäßen Verfahren ist es ferner problemlos möglich, Schaltungsträger im sogenannten "landless design" herzustellen. Indem der Querschnitt der Leiterzüge reproduzierbar gebildet wird, bestehen keine Probleme bei der Realisierung dieser Technik. Auch lochfraß-ähnliche Ausätzungen im Leitermuster nach dem Ätzen der Kupferschicht werden nicht beobachtet.

Ferner treten bei der Entfernung der Schutzschicht nach dem Ätzen der Kupferschicht keine Probleme auf. Darüber hinaus kann die Schutzschicht im Gegensatz zu den bekannten Verfahren aus sehr engen Ausnehmungen und sogar Sacklöchern mit verdünnter anorganischer Säure entfernt werden.

Ferner bestehen keine Probleme bei der weiteren Verarbeitung der geätzten Schaltungsträger, wenn das erfindungsgemäße Verfahren angewendet wird. Im Gegensatz zu den bekannten Verfahren bereitet das Aufbringen einer Lötstopmaske in diesem Falle ebenso wenig Schwierigkeiten wie die nachträgliche Abscheidung einer Nickel/Gold-Endschicht. Bei Anwendung des erfindungsgemäßen Verfahrens ist die Haftfestigkeit der Lötstopmaske auf den Leiterzügen ausreichend hoch, nach Anwendung der bekannten Verfahren können die Oberflächen der Leiterzüge vor dem Aufbringen der Endschicht dagegen nicht befriedigend geätzt werden.

Wird das erfindungsgemäße Verfahren eingesetzt, bereitet auch die abwassertechnische Behandlung der beim Entfernen der Schutzschicht entstehenden Flüssigkelten keine Probleme.

Gegenüber den herkömmlichen Strukturierungstechniken unter Verwendung von Photo- oder Siebdruckresisten ist das erfindungsgemäße Abtragsverfahren wesentlich kürzer und beansprucht weniger Verfahrensschritte. Insbesondere ist kein Entwicklungsschritt für die Schutzschicht erforderlich.

Zur Herstellung der Schutzschicht werden die Kupferschichten mit einer sauren Lösung in Kontakt gebracht, die vorzugsweise Wasser als Lösungsmittel enthält, gegebenenfalls auch andere Lösungsmittel als Wasser allein, in einer Mischung mit Wasser oder untereinander. Die Lösung enthält mindestens eine Stickstoff enthaltende Verbindung, beispielsweise eine cyclische, vorzugsweise heterocyclische und/oder aromatische Verbindung, insbesondere substituiert mit Alkylseitenketten oder ein Oligomeres oder Polymeres der cyclischen Verbindungen, sowie weitere Bestandtelle.

Die Konzentration dieser Stoffe in der Lösung kann beispielsweise im Bereich von 0,001 g/l bis 400 g/I eingesetzt werden, vorzugsweise von 1 g/l bis 50 g/l.

Außerdem enthält die die Stickstoffverbindungen enthaltende Lösung mindestens eine Säure, beispielsweise Phosphorsäure, Schwefelsäure, Salzsäure, phosphorige Säure, Ameisensäure, Essigsäure, Glykolsäure, Oxalsäure, Bernsteinsäure, Maleinsäure, Weinsäure, Adipinsäure oder Milchsäure.

Der pH-Wert der Lösung soll kleiner als 7 sein und liegt vorzugsweise im Bereich von 2 bis 5.

Die Lösung kann auch weitere Bestandteile enthalten, beispielsweise basische Substanzen zur pH-Stabilisierung (Pufferung), Kupfer- und/oder andere Schwermetaltsalze zur Härtung der Schicht. Als basische Substanzen können vorzugsweise aliphatische Amine eingesetzt werden, beispielsweise Ethylendiamin, Monoalkylamine, Dialkylamine und Ethanolamine, wie Mono-, Di- und Triethanolamin.

Zur Bildung der Schutzschicht wird die Lösung auf eine Temperatur von vorzugsweise 30°C bis 95°C erwärmt und etwa 2 min bis 10 min lang mit dem Substrat in Kontakt gebracht.

In einer Verfahrensvariante wird das Substrat während des In-Kontakt-Bringens mit der Lösung mit einer externen Stromquelle und einer ebenfalls mit der Lösung in Kontakt stehenden Gegenelektrode oder direkt mit einer zweiten Elektrode elektrisch verbunden, die ebenfalls mit der Behandlungslösung in Kontakt gebracht wird. Dabei wird die Schutzschicht durch elektrochemische Reaktion gebildet, indem während des In-Kontakt-Bringens der Kupferschichten mit der die Stickstoff enthaltende Verbindungen enthaltenden Lösung zumindest zeitweise eine elektrische Spannung zwischen den Kupferschichten und den Elektroden angelegt wird oder sich auf Grund der Normalpotentialdifferenz der Kupferschichten und der Elektroden derart einstellt, daß die Kupferschichten als Anode und die Elektrode als Kathode polarisiert werden. Dadurch fließt ein elektrischer Strom zwischen den Kupferschichten und den Elektroden.

Die Spannung zwischen der zweiten Elektrode bzw. der Gegenelektrode und dem Substrat wird vorzugsweise im Bereich von 0,5 Volt bis 1,5 Volt eingestellt. Der sich einstellende Strom liegt vorzugsweise im Bereich von 0,1 A/dm² bis 1 A/dm².

Falls keine externe Stromquelle verwendet und das Substrat mit der zweiten Elektrode direkt verbunden wird, wird als Material für die Elektrode ein Metall verwendet, das sich edler als Kupfer verhält, beispielsweise Edelstahl oder Gold.

Nach der Bildung der Schutzschicht wird das Substrat getrocknet, um die Schutzschicht zu verfestigen. Hierzu wird das Substrat beispielsweise in einem Umluft-Trockner oder mit diesem Verfahren einer IR-Strahlungsheizung getrocknet. Es kann auch eine Kombination aus Durchlauftrockner und IR-Strahlungsheizung oder Heißluftstrecke eingesetzt werden.

Danach wird das Substrat mit UV-Strahlung belichtet, vorzugsweise mit Laserstrahlung. Die Schutzschicht kann dadurch abgetragen werden, daß ein Laserstrahl über die Schutzschicht gefahren wird. Dadurch werden die Bereiche der Schutzschicht entfernt, die dem zu bildenden Leitermuster nicht entsprechen. Der Laser dient dazu, das organische Material der Schutzschicht aufzuschließen und in die Gasphase zu überführen. Als Laser ist vorzugsweise ein gepulster Excimer-Laser geeignet, mit der die Bindungen in den organischen Molekülen (photolytisch) aufgebrochen werden. Die entstehenden gasförmigen Produkte können über geeignete Pumpsysteme aus der unmittelbaren Umgebung des Substrats abgezogen werden, um eine erneute Schichtbildung zu verhindern.

Zur Abbildung des Leitermusters auf das mit der Metallschicht überzogene Substrat kann insbesondere eine von der UV-Strahlung durchstrahlte Maske eingesetzt werden.

Besonders günstig ist eine Abbildungsanordnung, bei der die Maske beabstandet zum Substrat in den parallelen Strahlengang des Lasers gebracht wird (off-contact-Verfahren). Das Muster der Maske wird dann direkt auf das Substrat übertragen. Für die Herstellung der Maske wird vorzugsweise eine mit dem Leiterzugmuster strukturierte dünne Chromschicht auf einem Quarzträger verwendet. Derartige Masken können mit einer Auflösung von etwa 0,2 µm hergestellt werden. In den Strahlengang zwischen Maske und Substrat kann ferner eine Abbildungsoptik eingebracht werden, mit der das Maskenbild auf die Schutzschicht vergrößert oder verkleinert abgebildet werden kann. Das Substrat befindet sich dann nicht im Fokus der Abbildungsoptik. Falls die Maske von dem Laserstrahl nicht vollständig ausgeleuchtet wird, weil der Laserstrahl keinen ausreichend großen Strahlquerschnitt aufweist, kann entweder die Maske senkrecht zum Laserstrahl verfahren oder der Laserstrahl über die Maske gefahren werden, so daß der Laserstrahl sequentiell alle Bereiche der Maske erfaßt. Dadurch kann das Muster der Maske abgerastert werden. Wird die Maske verfahren, so wird das Substrat in dazu koordinierter Bewegung ebenfalls verfahren.

In einer alternativen Anordnung kann die Maske auch in direkten Kontakt mit der Schutzschichtoberfläche gelegt werden. Dadurch sind Unterstrahlungseffekte zwar leichter als beim off-contact-Verfahren vermeidbar. Diese Anordnung weist jedoch den Nachteil auf, daß eine Abbildungsoptik zur Vergrößerung oder Verkleinerung des Maskenbildes nicht eingesetzt werden kann. Außerdem kann das Muster der Maske durch geeignetes koordiniertes Verfahren der Maske relativ zum Substrat nicht mehrfach auf die Schutzschichtoberfläche abgebildet werden. Das Problem der Unterstrahlung bei Anwendung des off-contact-Verfahrens kann dadurch weitgehend behoben werden, daß geeignete zusätzliche Blendensysteme zur Ausblendung von Streustrahlung am Rand eingesetzt werden.

Grundsätzlich kann das Leitermuster auch mit einem fokussierten Laserstrahl ohne Maske auf die Schutzschichtoberfläche "geschrieben" werden (Laser Direct Imageing). Indem ein sehr scharf fokussierter Laserstrahl verwendet wird, aus dem gegebenenfalls auch den Hauptstrahl umgebende Streustrahlung ausgeblendet wird und der über die Schutzschichtoberfläche verfahren wird, können ebenfalls sehr feine Strukturen in der Schutzschicht gebildet werden (50 µm).

Anschließend werden die freigelegten Kupferbereiche in einem Ätzverfahren entfernt. Hierzu wird vorzugsweise eine alkalische Kupferätzlösung (ammoniakalische Kupfer(II)chlorid-Ätzlösung) eingesetzt. Dabei werden die Leitermuster gebildet.

Danach wird die Schutzschicht von den gebildeten Kupferstrukturen entfernt. Hierzu wird eine saure Lösung verwendet. Unter anderem kann eine wäßrige Lösung einer anorganischen Säure eingesetzt werden, beispielsweise eine verdünnte Salzsäure- oder Schwefelsäurelösung.

Das entstandene Kupfermuster weist scharfkantige, sehr feine Kupferstrukturen auf, die steile und gerade Flanken besitzen.

Die Kupferschichten können in unterschiedlichen Verfahrenstechniken behandelt werden. Beispielsweise können die mit den Kupferschichten versehenen Substrate in die Behandlungslösungen eingetaucht werden, indem sie in Bäder eingesenkt werden, die in Behältern enthalten sind. Eine bevorzugte Methode zum In-Kontakt-Bringen der Substrate mit den Behandlungslösungen besteht darin, daß ein Horizontal-Durchlaufverfahren für die Bildung der Schutzschicht und zur Entfernung der freigelegten Kupferschichten angewendet wird. Dieses Verfahren besteht darin, daß die Substrate in horizontaler Transportrichtung durch eine derartige Anlage hindurchgeführt werden. Dabei werden die Substrate entweder senkrecht oder waagerecht gehalten. Dabei können die Substrate wiederum in einer horizontalen bzw. vertikalen Transportebene geführt werden. Die Lösungen können mittels geeigneter Düsen an die Substratoberflächen herangeführt werden, beispielsweise mit Schwall-, Spritz- oder Sprühdüsen. Mit den Düsen wird eine Zwangsdurchflutung auch feinster Ausnehmungen gewährleistet.

Zur Herstellung der hochintegrierten Schaltungsträger können Basismaterialien eingesetzt werden, die aus einem Dielektrikum bestehen, das an einer oder beiden Seiten mit Kupferschichten versehen ist. Derartige Basismaterialien können zum einen auf herkömmlichem Wege durch Laminieren von Kupferfolien mit einem noch nicht ausgehärteten harzgetränkten Glasfasergewebe oder durch Aufgießen oder Auflaminieren von Harz auf ein stabiles Trägersubstrat und Aushärten des Harzes hergestellt werden. Das Trägersubstrat wird vorzugsweise bereits auf konventionelle Weise als mehrlagiger Schaltungsträger mit gröberen Schaltungsstrukturen, beispielsweise zur Erdung, Stromversorgung oder Abschirmung, ausgebildet, die in geeigneter Weise über durchkontaktierte Ausnehmungen untereinander und/oder mit Signalverdrahtungsebenen auf den zusätzlich aufgebrachten Dielektrikumslagen elektrisch verbunden sind.

Entsprechend dem Bedarf an Verdrahtungsdichte können die Dielektrikumsschichten ein- oder beidseitig auf das Trägersubstrat aufgetragen werden.

Denkbar sind auch Mehrfachbeschichtungen unter jeweiliger Ausbildung eines Leitermusters in der neuen Lage möglich. Dadurch läßt sich die Signalverdrahtungsdichte nahezu beliebig steigern. Dabei versteht es sich von selbst, daß vor jedem weiteren Aufbau einer zusätzlichen Dielektrikumsschicht das jeweilige Leiterbild fertig ausgebildet sein muß.

Die Kupferschichten in den einzelnen Lagen können durch Metallisierung der Dielektrika hergestellt werden. Metallisierungsverfahren, mit denen ein ausreichend haftfester Verbund zwischen der Kupferschicht und dem Dielektrikum erzielbar ist, sind bekannt. Beispielsweise kann das Harz nach geeigneter (Ätz)vorbehandlung auf chemischem Wege metallisiert werden. Hierzu wird das Dielektrikum beispielsweise zuerst mit Edelmetallsalzen aktiviert und dann stromlos und gegebenenfalls elektrolytisch verkupfert. In einer anderen Verfahrensweise kann das Dielektrikum auch mit einem Plasmaverfahren metallisiert werden. Hierzu wird das Dielektrikum zuerst in einer Glimmentladung geätzt und danach - ebenfalls in einer Glimmentladung - mit Edelmetallsalzen beschichtet (PECVD-Verfahren, physikalische Auftragsverfahren, wie Sputtern usw.), so daß anschließend haftfest Kupfer mit einem stromlosen und gegebenenfalls elektrolytischen Verfahren abgeschieden werden kann.

Das elektrolytische Verfahren zum Aufbringen von Kupfer auf das Dielektrikum kann in herkömmlicher Weise mit Gleichstrom, vorteilhafterweise aber auch mit einem Pulsverfahren abgeschieden werden (pulse plating), bei dem uni- oder bipolare Strom- bzw. Spannungspulse angewendet werden. Typischerweise wird eine etwa 10 µm bis 20 µm dicke Kupferschicht gebildet.

Zur näheren Erläuterung der Erfindung dienen die nachfolgenden Beispiele:

### Beispiel 1:

Eine einseitig mit 17,5 µm dicker Kupferfolie kaschierte lsolierstoffplatte (FR4-Material: mit flammhemmendem Harz getränkte Glasfasermatten, ausgehärtet) wurde in einem galvanischen schwefelsauren Kupferbad (20 g/l Cu²⁺ als Kupfersulfat, 200 g/l H₂SO₄, 50 mg/l Cl⁻ als NaCl, Glanzbildner, Einebner) auf 20 µm Dicke verstärkt.

Anschließend wurde die verkupferte Platte in eine Beschichtungslösung zur Bildung der Schutzschicht eingetaucht. Diese Lösung wies folgende Zusammensetzung auf:

| | |
|---|---|
| 2-n-Pentylbenzimidazol | 10 g |
| Ameisensäure | 32 g |
| Kupfer(II)chlorid | 1,0 g |
| Auffüllen mit Wasser auf | 1 l. |

Die Platte wurde 5 Minuten lang in der auf 40°C erwärmten Lösung behandelt, anschließend mit Wasser gespült und danach in einem Umluft-Trockner 10 min lang bei 130°C getrocknet.

Durch die Behandlung mit der Lösung wurde ein dünner (im Bereich von 1 bis 10 µm dicker) organischer Film als Schutzschicht auf der Kupferschicht gebildet.

In einem Alternatiwersuch wurde anstelle von 2-n-Pentylbenzimidazol die Verbindung 2-n-Heptylbenzimidazol verwendet. Es wurde dasselbe Ergebnis erhalten.

Zur Bildung von Leiterstrukturen mit Strukturbreiten von 20 µm wurde die Schutzschicht danach mit einem gepulsten Excimer-Laser mit einer Laser-Ausgangsleistung von 50 W und einer Energiedichte von 150 mJ/cm² bis 200 mJ/cm² strukturiert. Hierzu wurde eine Maske (strukturierte Chromschicht mit Leitermuster auf einer Quarzplatte) in den Strahlengang des Lasers gebracht. Zwischen der Maske und der Isolierstoffplatte wurde eine Abbildungsoptik so positioniert, daß die Isolierstoffplatte von der Optik aus gesehen jenseits des Fokus des Strahles angeordnet war. Das Leitermuster der Maske wurde dadurch mit einem linearen Faktor 2 auf die Schutzschicht abgebildet. Da der Laserstrahl nur einen kleinen Teil der Maske ausleuchtete, wurden die Maske und die Isolierstoffplatte senkrecht zur Strahlachse und in entgegengesetzter Richtung zueinander koordiniert bewegt, so daß das gesamte Leitermuster sequentiell auf die Schutzschicht abgebildet wurde.

Das beim Laserstrukturieren freigelegte Kupfer wurde dann mit einer ammoniakalischen CuCl₂-Ätzlösung entfernt.

Im Anschluß daran wurde die organische Schicht in einer 3 Gew.-%igen HCl-Lösung wieder entfernt.

Es wurde ein aus Kupferleiterzügen bestehendes Muster gebildet, wobei die Leiterzüge etwa 20 µm Breite (an der Basis) und 20 µm Dicke aufwiesen.

Das Ätzergebnis wurde durch rasterelektronenmikroskopische Aufnahmen verifiziert: Die Leiterzüge wiesen einen sehr regelmäßigen Querschnitt auf, der trapezförmig ausgebildet war. Die Auflagefläche der Leiterzüge auf dem FR4-Material war größer als die Oberfläche der Leiterzüge. Die Flanken der Leiterzüge waren regelmäßig, gerade gebildet und so steil, daß die Unterätzung 2,5 µm betrug.

Einkerbungen, trichterförmige Ausätzungen und andere Unregelmäßigkeiten wurden nicht festgestellt.

Diese Ergebnisse wurden sowohl mit der Beschichtungslösung, enthaltend 2-n-Pentylbenzimidazol, als auch mit der Beschichtungslösung, enthaltend 2-n-Heptylbenzimidazol, erhalten.

### Beispiel 2:

Der Versuch von Beispiel 1 wurde wiederholt, wobei die Behandlung in der Benzimidazollösung zur Bildung der Schutzschicht unter Stromfluß durchgeführt wurde. Hierzu wurde eine weitere Elektrode aus platiniertem Titanstreckmetall mit der Lösung in Kontakt gebracht und zwischen den Kupferschichten und der Elektrode eine Spannung eingestellt, so daß ein Strom von etwa 0,2 A/dm² (bezogen auf die Kupferschichten) floß.

Es wurde dieselbe Lösung zur Bildung der Schutzschicht wie in Beispiel 1 und dieselbe Anordnung zur Bildung des Leitermusters in der Schutzschicht mit dem Excimerlaser verwendet.

Das Ätzergebnis war dasselbe wie in Beispiel 1.

### Beispiel 3:

Beispiel 2 wurde wiederholt. Allerdings wurde eine Lösung zur Bildung der Schutzschicht verwendet, die kein Kupter(II)chlorid enthielt.

Das Ätzergebnis war dasselbe wie in Beispiel 1.

## Patentansprüche

1. Verfahren zum Bilden eines Leitermusters auf dielektrischen Substraten, bei dem
a) ein mit einer Metallschicht überzogenes Substrat mit einer Schutzschicht beschichtet wird, die durch Behandeln der Metallschicht mit einer mindestens eine Stickstoff enthaltende Verbindungen enthaltenden Lösung gebildet wird,
b) die Schutzschicht in den dem zu bildenden Leitermuster nicht entsprechenden Bereichen durch UV-Strahlung derart abgetragen wird, daß die Metallschicht freigelegt wird, und
c) die freigelegte Metallschicht durch Ätzen entfernt wird,
**dadurch gekennzeichnet, daß**
i. die Stickstoff enthaltenden Verbindungen ausgewählt werden aus der Gruppe der Verbindungen, bestehend aus mit Alkyl-, Aryl-und/oder Aralkylgruppen substituierten Imidazolen, Benzimidazolen, Triazolen, Benzotriazolen, Pyrrolen, Pyrazolen, Oxazolen, Isoxazolen, Thiazolen, Benzothiasolen, Indolen, Adenin, Purinen, Chinolinen, Pyrazinen, Chinazolinen, Guanin, Xanthin, Hypoxanthin, Indazolen, Kreatinin, Phenazinen, Kupferron, Tetrazolen, Thiadiazolen, Thiatriazolen, Isothiazolen sowie deren Derivaten, wobei die Alkylgruppen mindestens drei Kohlenstoffatome aufweisen, oder
ii. die Stickstoff enthaltenden Verbindungen Oligomer- oder Polymerketten enthalten, an die Verbindungen gebunden sind, die ausgewählt werden aus der Gruppe der Verbindungen, bestehend aus mit Alkyl-, Aryl- und/oder Aralkylgruppen substituierten Imidazolen, Benzimidazolen, Triazolen, Benzotriazolen, Pyrrolen, Pyrazolen, Oxazolen, Isoxazolen, Thiazolen, Benzothiazolen, Indolen, Adenin, Purinen, Chinolinen, Pyrazinen, Chinazolinen, Guanin, Xanthin, Hypoxanthin, Indazolen, Kreatinin, Phenazinen, Kupferron, Tetrazolen, Thiadiazolen, Thiatriazolen, Isothiazolen sowie deren Derivaten, wobei die Alkylgruppen mindestens drei Kohlenstoffatome aufweisen.

2. Verfahren nach Anspruch 1, **dadurch gekennzeichnet, daß** das Leitermuster auf einem mit einer Kupferschicht überzogenen Substrat gebildet wird.

3. Verfahren nach einem der vorstehenden Ansprüche, **dadurch gekennzeichnet, daß** Laserstrahlung als UV-Strahlung eingesetzt wird.

4. Verfahren nach einem der vorstehenden Ansprüche, **dadurch gekennzeichnet, daß** die Schutzschicht in den freizulegenden Metallschichtbereichen in Verfahrensschritt b) unter Verwendung eines gepulsten Excimer-Lasers entfernt wird.

5. Verfahren nach einem der vorstehenden Ansprüche, **dadurch gekennzeichnet, daß** eine von der UV-Strahlung durchstrahlte Maske zur Abbildung des Leitermusters auf das mit der Metallschicht überzogene Substrat eingesetzt wird.

6. Verfahren nach einem der vorstehenden Ansprüche, **dadurch gekennzeichnet, daß** die Schutzschicht durch in-Kontakt-Bringen der Metallschichten mit einer wäßrigen, sauren Lösung der mindestens einen Stickstoff enthaltenden Verbindung gebildet wird.

7. Verfahren nach einem der vorstehenden Ansprüche, **dadurch gekennzeichnet, daß** die Lösung zur Bildung der Schutzschicht mindestens eine Säure enthält, ausgewählt aus der Gruppe, bestehend aus Phosphorsäure, Schwefelsäure, Salzsäure, phosphorige Säure, Ameisensäure, Essigsäure, Glykolsäure, Oxalsäure, Bernsteinsäure, Maleinsäure, Weinsäure, Adipinsäure und Milchsäure.

8. Verfahren nach einem der vorstehenden Ansprüche, **dadurch gekennzeichnet, daß** die Schutzschicht durch elektrochemische Reaktion gebildet wird, indem während des in-Kontakt-Bringens der Metallschichten mit der die Stickstoff enthaltende Verbindungen enthaltenden Lösung zumindest zeitweise eine elektrische Spannung zwischen den Metallschichten und mit der Lösung in Kontakt gebrachten Elektroden angelegt wird oder sich auf Grund der Normalpotentialdifferenz der Metallschichten und der Elektroden derart einstellt, daß die Metallschichten als Anode und die Elektrode als Kathode polarisiert werden, so daß ein elektrischer Strom zwischen den Metallschichten und den Elektroden fließt.

9. Verfahren nach einem der vorstehenden Ansprüche, **dadurch gekennzeichnet, daß** die freigelegte Metallschicht mit einer alkalischen Metall-Atlösung entfernt wird.

10. Verfahren nach einem der vorstehenden Ansprüche, **dadurch gekennzeichnet, daß** ein Horizontal-Durchlaufverfahren für die Bildung der Schutzschicht und die Entfernung der freigelegten Metallschichten angewendet wird.

11. Verfahren nach einem der vorstehenden Ansprüche, **dadurch gekennzeichnet, daß** die Schutzschicht nach dem Entfernen der Metallschicht abgetragen wird.

## Claims

1. Method of forming a conductive pattern on dielectric substrates, wherein
a) a substrate, which is coated with a metal layer, is covered with a protective layer which is formed by treating the metal layer with a solution which contains compounds containing at least one nitrogen,
b) the protective layer is removed by UV radiation in the regions which do not correspond to the conductive pattern to be formed, in such a manner that the metal layer is exposed, and
c) the exposed metal layer is removed by etching,
**characterised in that**
i) the nitrogen-containing compounds are selected from the group of compounds consisting of imidazoles, benzimidazoles, triazoles, benzotriazoles, pyrroles, pyrazoles, oxazoles, isoxazoles, thiazoles, benzothiazoles, indoles, adenine, purines, quinolines, pyrazines, quinazolines, guanine, xanthine, hypoxanthine, indazoles, creatinine, phenazines, cupferron, tetrazoles, thiadiazoles, thiatriazoles, isothiazoles and derivatives thereof, which compounds are substituted with alkyl, aryl and/or aralkyl groups, the alkyl groups having at least three carbon atoms, or
ii) the nitrogen-containing compounds contain oligomer or polymer chains, to which compounds are bonded, which are selected from the group of compounds consisting of imidazoles, benzimidazoles, triazoles, benzotriazoles, pyrroles, pyrazoles, oxazoles, isoxazoles, thiazoles, berizothiazoles, indoles, adenine, purines, quinolines, pyrazines, quinazolines, guanine, xanthine, hypoxanthine, indazoles, creatinine, phenazines, cupferron, tetrazoles, thiadiazoles, thiatriazoles, isothiazoles and derivatives thereof, which compounds are substituted with alkyl, aryl and/or aralkyl groups, the alkyl groups having at least three carbon atoms.

2. Method according to claim 1, **characterised in that** the conductive pattern is formed on a substrate which is coated with a copper layer.

3. Method according to one of the preceding claims, **characterised in that** laser radiation is used as the UV radiation.

4. Method according to one of the preceding claims, **characterised in that** the protective layer is removed in the metal layer regions which are to be exposed in method step b) by using a pulsed excimer laser.

5. Method according to one of the preceding claims, **characterised in that** a mask, which is irradiated by the UV radiation, is used to reproduce the conductive pattern onto the substrate which is coated with the metal layer.

6. Method according to one of the preceding claims, **characterised in that** the protective layer is formed by bringing the metal layers into contact with an aqueous, acidic solution of the compound which contains at least one nitrogen.

7. Method according to one of the preceding claims, **characterised in that** the solution for the formation of the protective layer contains at least one acid selected from the group consisting of phosphoric acid, sulphuric acid, hydrochloric acid, phosphorous acid formic acid, acetic acid, glycolic acid, oxalic acid, succinic acid, maleic acid, tartaric acid, adipic acid and lactic acid.

8. Method according to one of the preceding claims, **characterised in that** the protective layer is formed by an electrochemical reaction, **in that**, whilst the metal layers are being brought into contact with the solution containing the nitrogen-containing compounds, an electrical voltage is applied, at least occasionally, between the metal layers and electrodes, which are brought into contact with the solution, or, because of the difference in the normal potential of the metal layers and the electrodes, an electrical voltage is set in such a manner that the metal layers are polarised as the anode, and the electrode is polarised as the cathode, so that an electric current flows between the metal layers and the electrodes.

9. Method according to one of the preceding claims, **characterised in that** the exposed metal layer is removed with an alkaline metal etching solution.

10. Method according to one of the preceding claims, **characterised in that** a horizontal continuous method is used for the formation of the protective layer and for the removal of the exposed metal layers.

11. Method according to one of the preceding claims, **characterised in that** the protective layer is removed after the removal of the metal layer.

## Revendications

1. Procédé pour former un motif conducteur sur des substrats diélectriques, dans lequel
a) un substrat recouvert d'une couche métallique est revêtu avec une couche de protection qui est formée par traitement de la couche métallique avec une solution contenant au moins un composé contenant de l'azote,
b) la couche de protection est enlevée dans les zones qui ne correspondent pas au motif à former, par exposition à un rayonnement ultraviolet, de façon à mettre à nu la couche métallique, et
c) la couche métallique mise à nu est enlevée par gravure,
**caractérisé en ce que**
i. les composés contenant de l'azote sont choisis dans le groupe des composés comprenant des imidazoles, des benzimidazoles, des triazoles, des benzotriazoles, des pyrroles, des pyrazoles, des oxazoles, des isoxazoles, des thiazoles, des benzothiazoles, des indoles, l'adénine, des purines, des quinoléines, des pyrazines, des quinazolines, la guanine, la xanthine, l'hypoxanthine, des indazoles, la créatinine, des phénazines, le cupferron, des tétrazoles, des thiadiazoles, des thiatriazoles, des isothiazoles, substitués par des groupes alkyle, aryle et/ou aralkyle, ainsi que des dérivés de ceux-ci, les groupes alkyles présentant au moins trois atomes de carbone, ou
ii. les composés contenant de l'azote contiennent des chaînes oligomères ou polymères auxquelles sont reliés des composés qui sont choisis dans le groupe des composés comprenant des imidazoles, des benzimidazoles, des triazoles, des benzotriazoles, des pyrroles, des pyrazoles, des oxazoles, des isoxazoles, des thiazoles, des benzothiazoles, des indoles, l'adénine, des purines, des quinoléines, des pyrazines, des quinazolines, la guanine, la xanthine, l'hypoxanthine, des indazoles, la créatinine, des phénazines, le cupferron, des tétrazoles, des thiadiazoles, des thiatriazoles, des isothiazoles, substitués par des groupes alkyle, aryle et/ou aralkyle, ainsi que des dérivés de ceux-ci, les groupes alkyles présentant au moins trois atomes de carbone.

2. Procédé selon la revendication 1, **caractérisé en ce que** le motif conducteur est formé sur un substrat recouvert d'une couche de cuivre.

3. Procédé selon l'une des revendications précédentes, **caractérisé en ce que** le rayonnement ultraviolet utilisé est un rayonnement laser.

4. Procédé selon l'une des revendications précédentes, **caractérisé en ce que**, dans l'étape de procédé b), la couche de protection est enlevée dans les zones à mettre à nu de la couche métallique en se servant d'un laser excimère pulsé.

5. Procédé selon l'une des revendications précédentes, **caractérisé en ce que**, pour former le motif conducteur sur le substrat recouvert par la couche métallique, on utilise un masque traversé par le rayonnement ultraviolet.

6. Procédé selon l'une des revendications précédentes, **caractérisé en ce que** la couche de protection est formée par la mise en contact des couches métalliques avec une solution aqueuse acide du composé contenant au moins un azote.

7. Procédé selon l'une des revendications précédentes, **caractérisé en ce que** la solution servant à former la couche de protection contient au moins un acide choisi dans le groupe constitué par l'acide phosphorique, l'acide sulfurique, l'acide chlorhydrique, l'acide phosphoreux, l'acide formique, l'acide acétique, l'acide glycolique, l'acide oxalique, l'acide succinique, l'acide maléique, l'acide tartrique, l'acide adipique et l'acide lactique.

8. Procédé selon l'une des revendications précédentes, **caractérisé en ce que** la couche de protection est formée par une réaction électrochimique, au moyen d'une tension électrique qui est appliquée au moins par intermittence, pendant la mise en contact des couches métalliques avec la solution contenant des composés contenant de l'azote, entre les couches métalliques et des électrodes mises en contact avec la solution ou qui s'établit d'elle-même du fait de la différence de potentiel normale, de telle sorte que les couches métalliques sont polarisées en tant qu'anode et l'électrode en tant que cathode de façon qu'un courant électrique s'écoule entre les couches métalliques et les électrodes.

9. Procédé selon l'une des revendications précédentes, **caractérisé en ce que** la couche métallique mise à nu est enlevée avec une solution de gravure à base de métal alcalin.

10. Procédé selon l'une des revendications précédentes, **caractérisé en ce que**, pour former la couche de protection et enlever les couches métalliques mises à nu, on utilise un procédé à passage horizontal.

11. Procédé selon l'une des revendications précédentes, **caractérisé en ce que** la couche de protection est enlevée après l'enlèvement de la couche métallique.
